Europäisches Patentamt

European Patent Office

Office européen des brevets

(19)

(11) Numéro de publication : **0 484 228 A1**

# (12) DEMANDE DE BREVET EUROPEEN

(21) Numéro de dépôt : **91402896.4**

(22) Date de dépôt : **29.10.91**

(51) Int. Cl.⁵ : **H04B 10/14,** H01S 3/103

(30) Priorité : **31.10.90 FR 9013528**

(43) Date de publication de la demande :
**06.05.92 Bulletin 92/19**

(84) Etats contractants désignés :
**DE GB**

(71) Demandeur : **FRANCE TELECOM Etablissement autonome de droit Public (Centre National d'Etudes des Télécommunications), 38/40 rue du Général Leclerc**
**F-92131 Issy les Moulineaux (FR)**

(72) Inventeur : **Chawki, Mouhamed**
**34 Boulevard d'Armor**
**F-22300 Lannion (FR)**
Inventeur : **Potier, Patrice**
**10 rue des Capucines**
**F-22300 Lannion (FR)**
Inventeur : **Auffret, René**
**Kernu Louannec**
**F-22700 Perros-Guirec (FR)**

(74) Mandataire : **Mongrédien, André et al**
**c/o BREVATOME 25, rue de Ponthieu**
**F-75008 Paris (FR)**

(54) **Procédé de transmission optique par décalage en longueur d'onde et système correspondant.**

(57) Selon l'invention, on procède à un saut en longueur d'onde correspondant à un saut de mode du laser. Le laser (20) est alimenté par deux courants qui fixent les longueurs d'onde d'émission ($\lambda 1$, $\lambda 2$).

Application aux télécommunications optiques.

FIG.1

EP 0 484 228 A1

La présente invention a pour objet un procédé de transmission optique par décalage en longueur d'onde et un système correspondant.

Elle trouve une application en télécommunications optiques.

Les lasers à semi-conducteurs se prêtent bien aux télécommunications optiques en raison notamment de la possibilité qu'ils offrent de réaliser des modulations d'amplitude, de phase ou de fréquence.

Récemment, sont apparus des lasers à semi-conducteurs à plusieurs sections qui ont permis de perfectionner encore ces techniques.

On connaît ainsi un procédé de transmission optique mettant en oeuvre la technique dite FSK pour "Frequency Shift Keying" (codage par décalage en fréquence) utilisant un laser à deux sections. Un tel procédé est décrit par exemple dans l'article de H. KOBRINSKI et al., intitulé : "Fast Wavelength Switching and Simultaneous FSK Modulation Using Tunable DBR Laser", et publié dans la revue "Electron. Lett. ", 1990, 26, pp. 308-310.

De même, il est connu que ces structures multiélectrodes, lorsqu'elles sont du type DFB (pour "Distributed Feedback" ou à réaction distribuée) peuvent être utilisées pour la commutation, comme décrit dans l'article de H. SHOJI et al., intitulé "New Bistable Wavelength Switching Device Using a Two-Electrode Distributed Feedback Laser" et publié dans la revue "Electron. Lett.", 1988, 24, pp. 888-889. Ces structures peuvent aussi être utilisées pour la réalisation de circuits logiques, comme décrit dans l'article de K.Y. LIOU et al., intitulé "Electro-Optical Logic Operations with Two-Electrode Distributed Feedback Injections Lasers" et publié dans la revue "Appl. Phys. Lett.", 1989, 51, pp. 1777-1779.

Par ailleurs, une technique d'adressage par commutation entre plusieurs longueurs d'onde d'un même laser DFB à double section a été décrite par J.M. COOPER et al. dans un article intitulé "Nano-second Tunable Double-Section DFB Laser for Dynamic Wavelength Addressing Applications" publié dans la revue "Electron. Lett.", 1988, 24, pp. 1237-1239.

La présente invention a pour but de proposer une technique mettant encore en oeuvre de tels lasers multiélectrodes (ou multisections) en vue, non plus d'obtenir une modulation FSK, une commutation ou des opérations logiques, mais d'effectuer une transmission optique de signal binaire. Le phénomène mis en oeuvre est un saut de longueur d'onde du rayonnement émis. Les demandeurs désignent leur technique par "codage par déplacement en longueur d'onde", ou, en terminologie anglosaxonne, "Wavelength Shift Keying" ou, en abrégé, WSK (Marque déposée).

Le décalage en longueur d'onde est obtenu par le choix judicieux des courants injectés dans une structure semi-conductrice à deux sections. Grâce à l'invention, il est possible d'obtenir une transmission de débit supérieur à 2 Gbit/s avec un taux d'erreur de l'ordre de $10^{-9}$.

Bien que le phénomène de décalage en longueur d'onde (WSK) selon l'invention soit, d'une certaine manière, un phénomène de décalage en fréquence comme en FSK, il existe des différences importantes entre les deux techniques (WSK et FSK), qui méritent d'être soulignées :

– alors qu'en FSK (c'est-à-dire selon l'art antérieur), un courant de modulation de quelques milliampères conduit à une excursion de fréquence de quelques Gigahertz, en WSK (c'est-à-dire selon l'invention), une telle modulation de quelques milliampères provoque un décalage de plus de 100 Gigahertz (soit environ 1 nm en longueur d'onde) ; il est alors beaucoup plus facile, selon l'invention, de démoduler le signal modulé en longueur d'onde ;

– alors qu'en FSK (c'est-à-dire selon l'art antérieur), le phénomène mis en jeu est un glissement d'un même mode d'oscillation, en WSK (c'est-à-dire selon l'invention), il s'agit d'un saut de mode.

De façon précise, l'invention a donc pour objet un procédé de transmission optique à l'aide d'un laser à semi-conducteur, caractérisé par le fait qu'il consiste :

A) dans un module d'émission :

– à former un signal binaire pouvant prendre une première ou une seconde valeur logique,

– à alimenter un laser à semiconducteur à deux électrodes par deux courants, l'un étant un courant de polarisation I1, l'autre un courant de polarisation I2 auquel est superposé un courant de commutation Ic, le laser oscillant sur un premier mode situé à une première longueur d'onde pour les courants I1 et I2, et sur un second mode à une seconde longueur d'onde, pour les courants I1 et I2+Ic, ces deux longueurs d'onde étant séparées de plus d'un nanomètre environ,

B) dans un module de réception :

– à recevoir le rayonnement transmis par le laser,

– à déterminer s'il est à la première ou à la seconde longueur d'onde.

La présente invention a également pour objet un système pour mettre en oeuvre ce procédé.

De toute façon, les caractéristiques et avantages de l'invention apparaîtront mieux à la lumière de la description qui va suivre. Cette description porte sur des exemples de réalisation donnés à titre explicatif et nullement limitatif et se réfère à des dessins annexés sur lesquels :

– la figure 1 montre schématiquement un système de transmission conforme à l'invention ;

– la figure 2 montre le spectre émis par un laser utilisé selon l'invention ;

– la figure 3 montre la réponse spectrale des deux modes d'oscillation du laser entre 0,1 GHz et 3,6 GHz ;

– la figure 4 montre la variation du taux d'erreur (BER) en fonction de la puissance reçue pour les deux modes utilisés.

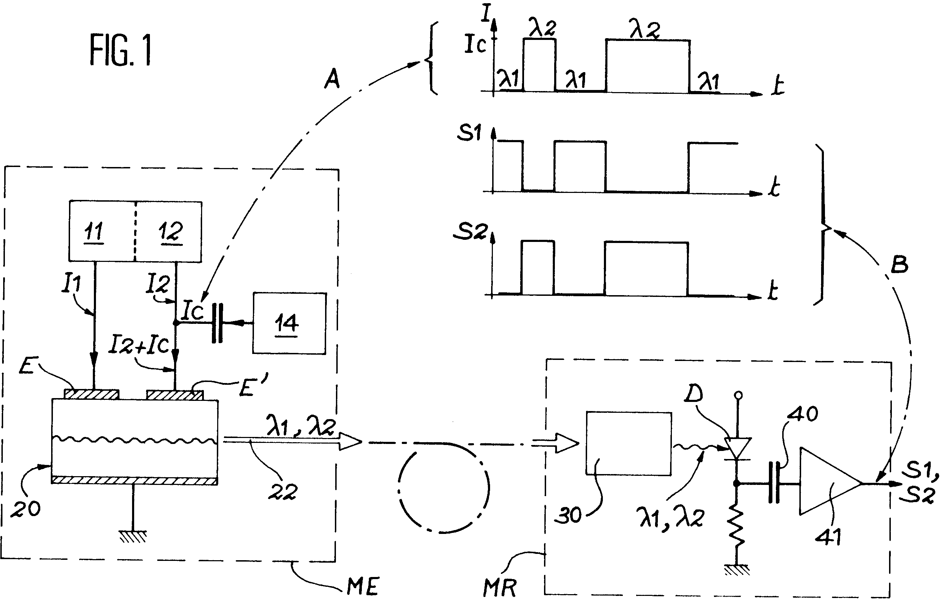

On voit sur la figure 1 un module d'émission ME et un module de réception MR. Le module d'émission ME comprend un laser à semiconducteur de type à contre réaction distribuée (ou DFB pour "Distributed Feedback"), à deux électrodes E, E'. Le laser est capable d'osciller à un premier ou à un second mode et d'émettre en conséquence un rayonnement à une première ou à une seconde longueur d'onde, respectivement λ1 ou λ2, selon la valeur d'un courant de commutation Ic appliquée sur l'électrode E' par exemple.

Deux courants de polarisation I1 et I2 sont appliqués respectivement sur les électrodes E et E'. De plus, sur l'électrode E', on applique le courant de commutation Ic, pouvant prendre deux valeurs logiques 0 et Ic correspondant au fonctionnement du laser soit sur le mode de longueur d'onde λ1, soit sur le mode de longueur d'onde λ2. Le courant de polarisation est représenté sur la partie A.

Le rayonnement émis par le laser se propage ensuite soit en espace libre, soit dans une structure de guidage comme une fibre optique monomode. Le rayonnement est ensuite reçu et traité par le module de réception MR.

Le module de réception comprend un filtre optique passe-bande 30 (un Fabry-Pérot par exemple) calé sur l'une ou l'autre des longueurs d'ondes λ1 ou λ2. Un photodétecteur D détecte le signal transmis à la sortie du filtre 30. Il est suivi d'un condensateur 40 et d'un amplificateur 41 délivrant un signal de sortie S1 ou S2. Selon que le filtre est calé sur l'une ou l'autre des longueurs d'onde, le signal de sortie S correspondra au signal de commutation ou à son complément. Ces signaux sont représentés sur la partie B. Le premier (S1) correspond au cas où le filtre 30 est câlé sur λ1, le second (S2) au cas où le filtre est câlé sur λ2.

Les demandeurs ont réalisé un tel système avec, à l'émission, un laser en GaInAsP sur InP de type DFB avec une structure BRS ("Buried Ridge Structure" ou structure à ruban enterré). Une' telle structure peut être obtenue par la tecnnique de dépôt dite MOCVD. Le laser utilisé possédait deux électrodes identiques de 200 micromètres chacune. L'électrode sur la face arrière du substrat était connectée à une résistance de 47 Ohms.

Ce laser présentait une plage d'accord continu sur 1nm avec une largeur de bande minimum de 15MHz. Il était sujet à un saut de mode selon la valeur des courants injectés. Par exemple, avec I1 fixé à 50mA et I'1 variant de 53mA à 55mA, le mode d'oscillation saute de λ1=1520,8nm à λ2=1521,8nm ($\Delta\lambda=(\lambda 1-\lambda 2)=1nm$)).

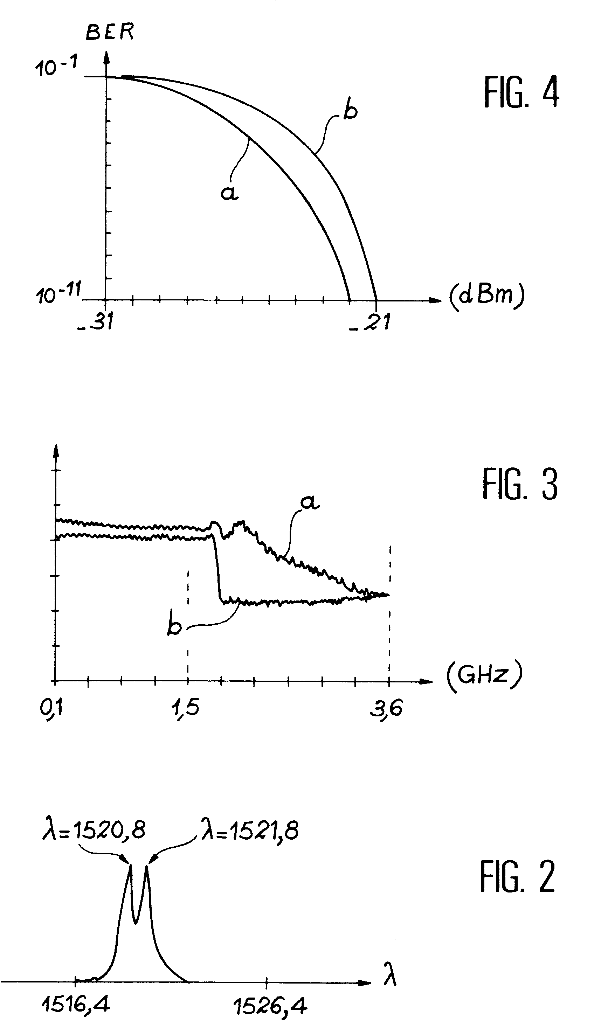

La figure 2 montre le spectre optique d'un tel laser présentant ce saut de mode lorsqu'un courant de modulation sinusoïdal de 7mA crête à crête à 700MHz est appliqué au courant I'1. La courbe montre les deux modes d'oscillation à λ1=1520,8nm et λ2=1521,8nm.

Pour évaluer la limitation de la vitesse de saut de longueur d'onde, les demandeurs ont mesuré la vitesse de commutation des deux modes. La figure 3 montre cette réponse pour les deux modes à λ1 (a) et à λ2 (b) mesurée de 0,1GHz à 3,6GHz. Le second mode (b) présente une discontinuité dans sa réponse à 1,7GHz. Le temps de commutation est inférieur à environ 550ps. Ce temps de commutation est limité par la durée de vie des porteurs dans la couche active du laser et par la capacité des électrodes.

Les performances du système de transmission de la figure 1 ont été testées en utilisant des séquences binaires pseudo-aléatoires avec non retour à zéro (NRZ-PBRS). A 1Gbit/s, le taux d'erreur (BER) en fonction de la puissance reçue (exprimée en dBm) est représenté sur la figure 4 pour les deux modes (courbes (a) et (b)). Pour un taux de $10^{-9}$ des sensibilités de -23dBm et -21 dBm ont été obtenues.

Le système de l'invention a été testé jusqu'à 2Gbit/s.

## Revendications

1. Procédé de transmission optique à l'aide d'un laser à semiconducteur, caractérisé par le fait qu'il consiste :

     A) dans un module d'émission (ME) :

          – à former un signal binaire pouvant prendre une première (o) ou une seconde (Ic) valeur logique,

          – à alimenter un laser à semiconducteur (20) à deux électrodes identiques (E, E') par deux courants, l'un étant un courant de polarisation (I1), l'autre un courant de polarisation (I2) auquel est superposé un courant de commutation (Ic), le laser oscillant sur un premier mode situé à une première longueur d'onde (λ1) pour les courants (I1) et (I2), et sur un second mode à une seconde longueur d'onde (λ2) pour les courants (I1) et (I2+Ic), ces deux longueurs d'onde (λ1, λ2) étant séparées de plus d'un nanomètre environ,

     B) dans un module de réception (MR) :

          – à recevoir le rayonnement transmis par le laser,

          – à déterminer s'il est à la première (λ1) ou à la seconde (λ2) longueur d'onde.

2. Système de transmission optique pour la mise en oeuvre du procédé selon la revendication 1, caractérisé par le fait qu'il comprend :

A) un module d'émission (ME) comprenant :
- deux circuits (11, 12) d'alimentation en courant de polarisation (I1) et (I2) et un circuit (14) d'alimentation en courant de commutation (Ic), ce circuit (14) recevant un signal binaire pouvant prendre une première ou une seconde valeur logique,
- un laser à semiconducteur (20) à deux ,électrodes identiques (E, E') reliées respectivement aux deux circuits (11, 12) et alimentées en courant de polarisation (I1, I2), l'une (E') étant en outre reliée au circuit (14) d'alimentation en courant de commutation (Ic), ce laser (20) oscillant à un premier ou à un second mode et émettant un rayonnement à une première ($\lambda$1) ou à une seconde ($\lambda$2) longueur d'onde selon que le couple de courants reçus sur ses électrodes (E, E') est (I1 et I2) ou (I1 et I2+Ic),

B) un module de réception (MR) comprenant :
- un filtre optique (30) recevant le rayonnement émis par le laser (20) et câlé soit sur la première ($\lambda$1) soit sur la seconde ($\lambda$2) longueur d'onde,
- un photodétecteur placé derrière le filtre (30) et délivrant soit le signal image du signal de modulation soit son complément selon que le filtre est ajusté à ($\lambda$1) ou à ($\lambda$2).

3. Système de transmission optique selon la revendication 2, caractérisé par le fait que le laser est du type à réaction distribuée (DFB).

4. Système de transmission optique selon la revendication 3, caractérisé par le fait que le laser est du type GaInAsP/InP à ruban enterré émettant à environ 1,5 m.

FIG. 1

FIG. 4

FIG. 3

FIG. 2

**Office européen des brevets**

# RAPPORT DE RECHERCHE EUROPEENNE

Numero de la demande

EP    91 40 2896

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0 290 191 (ATT)<br>* abrégé; figures 1,2,3 *<br>--- | 1-4 | H04B10/14<br>H01S3/103 |
| A | ELECTRONICS LETTERS.<br>vol. 23, no. 19, 10 Septembre 1987, STEVENAGE GB<br>pages 984 - 985;<br>H.YASAKA ET AL: 'Optical frequency scanning of a stabilised and linewidth-reduced multielectrode DFB laser using current feedback'<br>* page 984, colonne de droite, alinéa 4 -alinéa 5; figure 1 *<br>--- | 1-3 | |
| A | SECOND INTERNATIONAL CONFERENCE, INP AND RELATED MATERIALS<br>23 Avril 1990, DENVER,COLORADO,US<br>pages 185 - 188;<br>Y.KOTAKI ET AL: 'Narrow linewidth and wavelength tunable distributed feedback lasers'<br>* page 186, dernier alinéa - page 187, alinéa 3 *<br>* abrégé *<br>--- | 1-4 | |
| A | APPLIED PHYSICS LETTERS.<br>vol. 52, no. 1, 4 Janvier 1988, NEW YORK US<br>pages 10 - 12;<br>M.OHTSU ET AL: 'Correlated spontaneous emission between two longitudinal modes in an extended-cavity semiconductor laser'<br>* page 10, colonne de gauche, alinéa 1 - colonne de droite, alinéa 2; figure 1 *<br>--- | 1-4 | DOMAINES TECHNIQUES RECHERCHES (Int. Cl.5)<br><br>H04B<br>H01S |
| A | IEE PHOTONICS TECHNOLOGY LETTERS<br>vol. 2, no. 2, Février 1990, IEEE,NEW YORK,US<br>pages 139 - 142;<br>H.KOBRINSKI ET AL: 'Simultaneous fast wavelength switching and intensity modulation using a tunable DBR laser'<br>* page 139, alinéa 1 - page 141, alinéa 1 *<br>----- | 1-4 | |

Le présent rapport a été établi pour toutes les revendications

| Lieu de la recherche | Date d'achèvement de la recherche | Examinateur |
|---|---|---|
| LA HAYE | 17 JANVIER 1992 | GOUDELIS M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P0402)